# EUROPEAN PATENT APPLICATION

(11) **EP 1 964 906 A1**
(43) Date of publication of application: **03.09.2008**
(21) Application number: 06842981.0
(22) Date of filing: 21.12.2006
(51) Int. Cl.: C09K 11/64, C09K 11/08, H01L 33/00

(54) **YELLOW LIGHT-EMITTING PHOSPHOR AND WHITE LIGHT-EMITTING DEVICE USING SAME**

(30) Priority: 21.12.2005 JP 2005368207
(71) Applicant: NEC Lighting, Ltd., Shinagawa-ku Tokyo 141-0032 (JP)
(72) Inventor: YOSHIMATSU, Ryo, Shinagawa-ku, Tokyo 141-0032 (JP)
(74) Representative: Vossius & Partner
(86) International application number: PCT/JP2006/325473
(87) International publication number: WO 2007/072899

(57) **Abstract**

A novel yellow-emitting phosphor is represented by the general formula: Ca₁₋ₓAlSi₄N₇:Euₓ, and includes calcium (Ca), aluminum (Al), silicon (Si), europium (Eu), and nitrogen (N). In the general formula, x is preferably within a range of 0.001<x≤0.15. The yellow-emitting phosphor emits yellow light, which is a complementary color to blue, when excited by blue light and hence can be used to produce warm white light by being combined with a blue light emitting device.

## Description

### Technical Field:

The present invention relates to a yellow-emitting phosphor, and a white light emitting device and a lighting device each of which uses such a yellow-emitting phosphor.

### Background Art:

In recent years, light emitting diodes (LED) have been widely utilized in lamps, lighting equipment, and the like, as well as in lighting devices including backlights used in liquid crystal display devices because such an LED is small in size, exhibits a high power efficiency and a high luminance, and enjoys a prolonged life.

An LED itself is a light source having a single peak wavelength. Study has been made of use of such an LED as a white or daylight color light source, and a white light emitting device using an LED has been developed. Methods under study for realizing a white light emitting device using an LED include:
(a) combining three types of LEDs: blue, green, and red;
(b) combining a blue LED with a fluorescent material which emits yellow light, which is a complementary color to blue, when excited by blue light emitted from the blue LED;
(c) combining an ultraviolet LED with three types of fluorescent materials which emit blue light, green light and red light, respectively, when excited by ultraviolet rays from the ultraviolet LED; and
(d) combining a blue LED with fluorescent materials which emit red light and green light, respectively, when irradiated with light emitted from the blue LED.

The method (a) described above, which combines blue, green and red LEDs together, is based on an operating principle which is simple in itself in that rays of light of the three primary colors are mixed together to produce white light. However, this method involves a problem that three LED chips are needed while, at the same time, it is difficult to obtain a uniform emission color which does not depend on the viewing angle. By contrast, the methods (b), (c) and (d) described above, each of which uses fluorescence generated by excitation by light from the LED, are each capable of producing white light by the use of a single LED and each take over such a feature of the LED that a high optical energy can be obtained at a low power consumption. A light emitting device configured to emit white light which is constructed according to each of the aforementioned methods (b), (c) and (d), is also called a "white LED," attracts attention as a light emitting device for lighting purposes, and is being developed enthusiastically.

A white LED of the aforementioned type (b), wherein: a blue LED employing a nitride semiconductor is used; and a fluorescent material which emits yellow light as a complementary color to blue when irradiated with light emitted from the blue LED is dispersed in an encapsulating resin embracing the blue LED chip, is disclosed in JP-A-10-242513, for example. This publication mentions, as an example of the yellow-emitting fluorescent material, a YAG:Ce phosphor which comprises a YAG (yttrium-aluminum-garnet) type oxide known to have a composition: (Y, Gd)₃(Al, Ga)₅O₁₂, and Ce with which the host lattice of the YAG type oxide is doped. JP-A-11-046015 discloses a white LED constructed by forming on a blue LED chip a phosphor layer having non-particulate properties and containing a yellow-emitting fluorescent material similar to the above.

It is, however, difficult for such white LEDs of the above-described constructions to produce an emission of light having a longer wavelength within a visible light region because the YAG:Ce phosphor emits yellow-green fluorescence having a peak wavelength in the vicinity of 560 nm. For this reason, these white LEDs emit slightly bluish white light and hence involve a problem of poor color reproducibility and low color rendering properties. In cases where a white LED is used for lighting in actual life, such an LED is strongly desired to be capable of emitting slightly reddish warm white light.

A white LED of the three band type according to the aforementioned method (c) in which the ultraviolet LED (*i.e*., UV-LED) is combined with the blue-emitting phosphor, green-emitting phosphor and red-emitting phosphor, and a white LED of the three band type according to the aforementioned method (d) in which the blue LED is combined with the green-emitting phosphor and red-emitting phosphor, are being developed to solve the problem with the white LED of the two band type according to the aforementioned method (b).

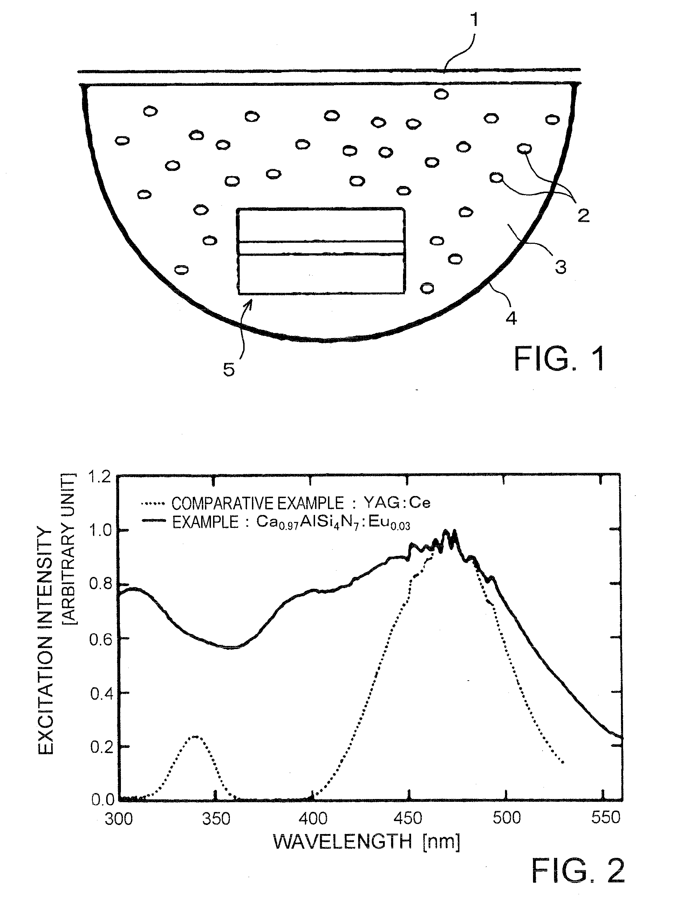

JP-A-2000-509912 discloses a white LED of the three band type in which a UV-LED is combined with a blue-emitting phosphor, green-emitting phosphor, and red-emitting phosphor. This white LED includes transparent substrate 1 used as a front panel, dome-shaped transparent resin layer 3 formed on transparent substrate 1, and UV-LED 5 disposed within transparent resin layer 3, as shown in FIG. 1. Transparent resin layer 3 is mixed with phosphor powder 2 comprising three types of phosphors which emit red light, green light, and blue light, respectively, when excited by ultraviolet light from UV-LED 5. The surface of dome-shaped transparent resin layer 3 is provided with a layer of a light reflecting material so as to serve as reflection mirror 4. JP-A-2000-500912 mentions: Y₂O₂S:Eu³⁺ and the like as examples of red-emitting phosphor; (Ba, Sr, Ca, Mg)₁₀(PO₄)₅Cl₂:Eu²⁺, BaMgAl₁₀O₁₇:Eu²⁺ and the like as examples of blue-emitting phosphors; and ZnS:(Cu, Al), BaMgAl₁₀O₁₇:(Eu, Mn) and the like as examples of green-emitting phosphors. UV-LED 5 used in this white LED has a high luminous efficiency over an emission wavelength range from 370 to 410 nm. Such phosphors suggested in JP-A-2000-509912, however, do not include any yellow-emitting phosphor. For further improvement in the color rendering properties of the white LED, enhancement of the emission intensity within the yellow region is needed.

Documents cited in the present description are listed below.
[1] JP-A-10-242513,
[2] JP-A-11-046015,
[3] JP-A-2000-509912,
[4] JP-A-2005-060714,
[5] JP-A-2005-235934,
[6] JP-A-10-093146,
[7] JP-A-10-065221.

### Disclosure of the Invention:

### Problem to be Solved by the invention:

Phosphors conventionally used in white light emitting devices (*i.e.*, white LEDs, white lasers, and the like) which use excitation sources including UV-LEDs and ultraviolet lasers for emitting ultraviolet rays and blue LEDs and blue lasers, cannot provide for emission of a satisfactory hue and hence make the color rendering properties of the white light emitting devices low. Therefore, when such a conventional white light emitting device is used for lighting, an object of some color may be seen in a color different from its original color. Thus, conventional white light emitting devices do not have adequate properties for applications in commodity display lighting and household lighting. Description will be made of the reasons that such conventional white light emitting devices do not have satisfactory color rendering properties.

The white light emitting device constructed according to the aforementioned method (c) is configured to excite the blue-emitting phosphor, green-emitting phosphor and red-emitting phosphor by the use of ultraviolet rays emitted from the UV-LED, thereby producing white light from blue light, green light and red light emitted from these phosphors. This white light emitting device exhibits an insufficient emission intensity in the yellow wavelength region and hence has a difficulty in enhancing its color rendering properties. Particularly problematic is a low special color rendering index R9 (red). The "special color rendering index," as used herein, is prescribed by JIS (Japanese Industrial Standards) Z8726 for evaluating the color rendering properties of light sources. Seven test colors corresponding to colors of actually existing objects are exposed to a light source to be tested, and how these test colors are seen under the light source is evaluated quantitatively by the special color rendering index. A value of special color rendering index is obtained for each of the test colors.

The white light emitting device according the aforementioned method (d) produces a white light emission from blue and a complementary color to blue. When the white light emitting device uses a combination of a blue LED and a phosphor of (Y, Gd)₃(Al, Ga)₅O₁₂:Ce³⁺ phosphor (YAG:Ce phosphor) which emits yellow light by absorbing blue light emitted from the blue LED, yellow light obtained from the phosphor has a wavelength within a shorter wavelength region than an optimum wavelength of the complementary color. For this reason, the device exhibits a low emission intensity within the red wavelength region and, therefore, cannot have satisfactory color rendering properties.

In attempt to improve such features, JP-A-2005-060714 and JP-A-2005-235934 disclose that warm white light emission can be obtained by mixing a phosphor that emits yellow-red or red light into a white light emitting device using a blue light source and a yellow-emitting phosphor. For example, JP-A-2005-060714 discloses that warm white light emission can be obtained by mixing a YAG type phosphor with a phosphor of Ca₂₋ₓSi₅N₈:Eu (x = 0.01 to 0.03) which emits light of a hue of intermediate orange and yellow having a peak wavelength of 610 to 614 nm.

By thus further mixing a phosphor that emits light of a complementary color to the color of excitation light with a phosphor that emits yellow-red or red light, it is possible to obtain warm white light emission. However, there still remains a problem that two kinds of phosphors are needed.

Accordingly, it is an object of the present invention to provide a novel yellow-emitting phosphor which is useful in constructing a white light emitting device having high color rendering properties.

It is another object of the present invention to provide a white light emitting device having such a yellow-emitting phosphor.

### Means for Solving the Problem:

A yellow-emitting phosphor according to the present invention is represented by the general formula: Ca₁-ₓAlSi₄N₇:Euₓ, and comprises calcium (Ca), aluminum (Al), silicon (Si), europium (Eu), and nitrogen (N). In the general formula of the yellow-emitting phosphor according to the present invention, x is preferably within a range of 0.001 <x≤0.15.

The use of the yellow-emitting nitride phosphor according to the present invention makes it possible to construct a white LED which emits white light of a warm incandescent bulb color. Further, a white light emitting device according to the present invention is configured to emit white light by combining blue light with light emitted from a phosphor which emits light of a complementary color to blue, wherein the phosphor is the yellow-emitting phosphor according to the present invention. The white light emitting device according to the present invention can be used to obtain warm white.

### Brief Description of the Drawings:

FIG. 1 is a schematic sectional view showing an exemplary structure of a white LED;
FIG. 2 is a diagram showing excitation spectra of YAG:Ce and Ca₀₋₉₇AlSi₄N₇:Eu_{0.03};
FIG. 3 is a diagram showing emission spectra of YAG:Ce and Ca_{0.97}AlSi₄N₇:Eu_{0.03};
FIG. 4 is a diagram showing a reflectance spectrum of Ca_{0.97}AlSi₄N₇:Eu_{0.03};
FIG. 5 is a diagram showing CIE chromaticity coordinate positions of respective emission spectra of YAG:Ce and Ca_{0.97}AlSi₄N₇:Eu_{0.03}; and
FIG. 6 is a diagram showing emission spectra of a yellow-emitting phosphor of Ca₁₋ₓAlSi₄N₇,Euₓ, with varying value of x.

### Description of Reference Numerals:

- 1: Transparent substrate;
- 2: Phosphor powder;
- 3: Transparent resin layer;
- 4: Reflection mirror;
- 5: UV-LED.

### Best Mode for Carrying Out the Invention:

As a result of repeated study and development of yellow-emitting phosphors, the inventors of the present invention have found out a yellow-emitting phosphor comprising calcium (Ca), aluminum (Al), silicon (Si), europium (Eu), and nitrogen (N), and represented by the general formula: Ca₁₋ₓAlSi₄N₇:Euₓ. As will be described later, the yellow-emitting phosphor comprising Ca₁₋ₓAlSi₄N₇:Euₓ has an excitation band extending within a wavelength range from about 300 to about 500 nm, *i.e.,* from ultraviolet to blue, and emits a yellow light having an emission peak at a wavelength in the vicinity of about 588 nm.

Since the yellow-emitting phosphor represented by the general formula: Ca₁₋ₓAlSi₄N₇:Euₓ has an excitation band within the wavelength range from 300 to 500 nm, the phosphor can be caused to emit yellow light by a light emitting device having an emission peak within the wavelength range from 300 to 500 nm. The yellow-emitting phosphor is capable of highly efficiently emitting yellow light having a peak in the vicinity of a wavelength of about 588 nm when irradiated with light emitted from, for example, an ultraviolet LED configured to emit ultraviolet rays having a wavelength of 365 nm, an ultraviolet LED configured to emit light having a wavelength of about 400 nm in the ultraviolet region, or a blue-green to pure green GaN-type LED configured to emit light having a wavelength in the vicinity of 400 to 500 nm. Examples of usable light sources for exciting the yellow-emitting phosphor according to the present invention include not only LEDs and laser diodes but also ultraviolet light emitting lamps, and self-emitting devices such as organic EL (Electroluminescence) devices and inorganic EL devices. Further, it is possible to use a light source in which a self-emitting device is combined with a phosphor which emits ultraviolet light or blue light when excited by light emitted from such a self-emitting device.

The emission peak wavelength of the yellow-emitting phosphor of the general formula: Ca₁₋ₓAlSi₄N₇:Euₓ is in the vicinity of 588 nm. An optimum complementary color to light having this peak wavelength is a blue color having a wavelength of about 440 to about 475 nm. Since such a wavelength range coincides with the emission range of a typical blue LED, white light having a warmer hue than conventional can be obtained by combining the yellow-emitting phosphor comprising Ca₁₋ₓAlSi₄N₇:Euₓ with such a blue LED. While a blue LED is illustrated here as a light source for exciting the yellow-emitting phosphor, the yellow-emitting phosphor may be combined with a light emitting device which emits blue light having a wavelength of 440 to 475 nm, or with a phosphor which emits blue light having a wavelength of 440 to 475 nm when irradiated with ultraviolet light. Even in such a case, a light emitting device, such as an inorganic EL device or organic EL device, may be used as a blue light emitting device. Unlike a light emitting device with a point light source such as an LED, such an inorganic or organic EL device is capable-of surface-emitting. For this reason, when an optimum emission wavelength can be obtained from such an EL device, a light emitting device using the EL device can be considered to be an optimum light emitting device for a lighting device.

In the case where a blue LED and the yellow-emitting phosphor according to the present invention are combined to construct a white light emitting device, the color rendering properties of such a light emitting device can be further improved by blending a red-emitting phosphor and a green-emitting phosphor with the yellow-emitting phosphor. Such a red-emitting phosphor which can be used in this case is a light emitting material having a main emission peak wavelength in a wavelength range from 600 to 660 nm, for example, CaS:Eu, (Ca, Sr)S:Eu, Ca₂Si₅N₈:Eu, CaAlSiN₃:Eu, or the like. Such a green-emitting phosphor which can be used is a light emitting material having a main emission peak wavelength in a wavelength range from 500 to 560 nm, for example, BaMgAl₁₀O₁₇:(Eu, Mn), SrGa₂S₄:Eu, SrAl₂O₄:Eu, Ba₂SiO₄:Eu, or the like. By thus adding the red-emitting phosphor having an emission peak wavelength of 600 to 660 nm and the green-emitting phosphor having an emission peak wavelength of 500 to 560 nm to the yellow-emitting phosphor, the resulting white light emitting device can be further improved in color rendering properties for use as a white light source.

White light can also be obtained by using a light emitting device configured to emit ultraviolet rays, for example, a UV-LED, ultraviolet emitting laser, ultraviolet lamp, or the like; a blue-emitting phosphor; and the yellow-emitting phosphor according to the present invention. The blue-emitting phosphor for use in this case emits blue light when excited by ultraviolet rays from the light emitting device, and preferably has an emission peak wavelength in the vicinity of 440 to 470 nm like the blue LED described above. Examples of such blue-emitting phosphors include (Sr, Ca, Ba)₁₀(PO₄)₅Cl:Eu, (Sr, Ca, Ba, Mg)₁₀(PO₄)₅Cl:Eu, and BaMgAl₁₀O₁₇:Eu. Even in these cases, the color rendering properties of the resulting white light emitting device can be further improved by blending a red-emitting phosphor and a green-emitting phosphor with the yellow-emitting phosphor. Such red-emitting phosphor and green-emitting phosphor for use in this case may be the aforementioned red-emitting phosphor and green-emitting phosphor, respectively. Like the combination of the blue light emitting device and the yellow-emitting phosphor, the combination of the yellow-emitting phosphor of the present invention and the ultraviolet emitting device improves the color rendering properties of the resulting light emitting device.

Description will be made of a method of preparing the yellow-emitting phosphor according to the present invention.

Raw materials used for synthesis of the yellow-emitting phosphor according to the present invention include: a calcium compound such as calcium nitride (Ca₃N₂); aluminum nitride (AIN); silicon nitride (Si₃N₄); and a europium compound such as europium oxide (Eu₂N₃). Such a calcium compound used here may be obtained by nitriding metallic calcium. Likewise, such a europium compound may be obtained by nitriding metallic europium.

These raw materials are weighed and collected according to the composition formula of the yellow-emitting phosphor of the present invention and then sufficiently mixed together by dry blending. Thereafter, the resulting mixture is charged into a heat-resistant vessel, such as a carbon crucible, carbon tray, boron nitride crucible, or boron nitride tray, and then fired at 1500 °C to 2000 °C for 3 to 10 hours in a reducing atmosphere comprising a mixture of hydrogen and nitrogen. The resulting fired mixture is milled and then subjected to process steps including washing, drying, and sifting, to give the yellow-emitting phosphor of the present invention. The mixing ratio between hydrogen and nitrogen for firing is preferably such as to provide a hydrogen atmosphere containing 10% to 90% of nitrogen. More preferably, the mixing ratio of nitrogen:hydrogen is 1:3. Instead of firing under the mixed atmosphere of hydrogen gas and nitrogen gas, firing under an ammonia atmosphere is possible. Alternatively, it is possible to perform firing under a high-pressure atmosphere having a nitrogen gas pressure of about 10 atm or lower. The resulting phosphor powder may be subjected to firing again.

### Examples:

Hereinafter, the yellow-emitting phosphor according to the present invention will be described more specifically based on Examples.

FIG. 2 is a diagram comparing respective measured excitation spectra of YAG:Ce (comparative example), which is a conventional yellow-emitting phosphor, and Ca_{0.97}AlSi₄N₇:Eu_{0.03} (Example), which is a yellow-emitting phosphor of the present invention. As shown in FIG. 2, the yellow- emitting phosphor of the present invention is efficiently excited by light having a wavelength ranging from 300 to 500 nm. Therefore, the yellow-emitting phosphor is suitable to be used with a combination with a UV-LED or a blue LED.

In the excitation spectrum of the conventional YAG type phosphor, there exists a steep spectral structure in the vicinity of a wavelength of 470 nm, which is an emission peak wavelength of a blue laser. For this reason, when a blue LED is combined with the YAG type yellow-emitting phosphor, a color shift may occur due to variability of the emission wavelength of the blue LED. By contrast, in the excitation spectrum of the yellow-emitting phosphor represented by the general formula: Ca₁₋ₓAlSi₄N₇:Euₓ (0.001 < x ≤ 0.15) according to the present invention, there exits no such steep structure in the vicinity of the wavelength of 470 nm as with the conventional YAG type phosphor. Thus, the use of the yellow-emitting phosphor according to the present invention makes it possible to prevent a color shift of white light from occurring in spite of variability of the emission wavelength of the blue LED used as an excitation light source.

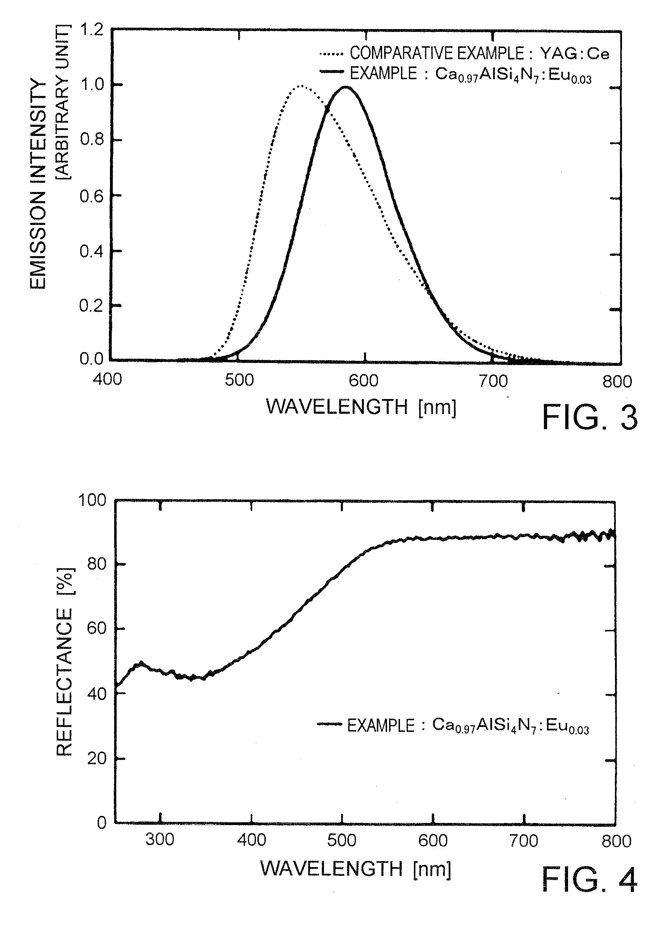

FIG. 3 is a diagram comparing respective measured emission spectra of YAG:Ce (comparative example), which is the conventional yellow-emitting phosphor, and Ca_{0.97}AlSi₄N₇.Eu_{0.03} (Example), which is the yellow-emitting phosphor of the present invention. As can be seen from FIG. 3, the yellow-emitting phosphor according to the present invention has an emission peak wavelength in the vicinity of a wavelength of 584 nm and hence has a high emission intensity in a red region, which is a longer wavelength component, in comparison with YAG:Ce fluorescent substance. Table 1 shows CIE chromaticity coordinates of respective emission colors of the YAG:Ce phosphor and the Ca_{0.97}AlSi₄N₇:Eu_{0.03} phosphor. The values of chromaticity coordinates shown are calculated from the emission spectra shown in FIG. 3. As can be seen from the values of chromaticity coordinates, the yellow-emitting phosphor of the present invention emits more reddish yellow light.

**Table 1**

| | PHOSPHOR | CIE CHROMATICITY COORDINATES (x, y) | WHITE CHROMATICITY OF BLACK-BODY RADIATION |
|---|---|---|---|
| COMPARATIVE EXAMPLE | YAG : Ce | (0.427, 0.551) | (0.27, 0.28) |
| EXAMPLE | Ca_{0.97}AlSi₄N₇:Eu_{0.03} | (0.509, 0.483) | (0.43, 0.41) |

Fig. 4 shows a measured reflectance spectrum of the Ca_{0.97}AlSi₄N₇:Eu_{0.03} phosphor. The reflectance spectrum suggests that this phosphor absorbs light having a wavelength of not more than 550 nm; stated otherwise, the phosphor can be excited by light having a wavelength of not more than 550 nm.

Description will be made of white LEDs each comprising a combination of a blue LED and a phosphor that emits yellow light having a complementary color relationship with blue by comparing a case where the conventional YAG:Ce was used as the yellow-emitting phosphor with a case where the Ca_{0.97}AlSi₄N₇:Eu_{0.03} phosphor according to the present invention was used as the yellow-emitting phosphor. The blue LED used was a blue LED which emits light having CIE chromaticity coordinates (0.130, 0.075).

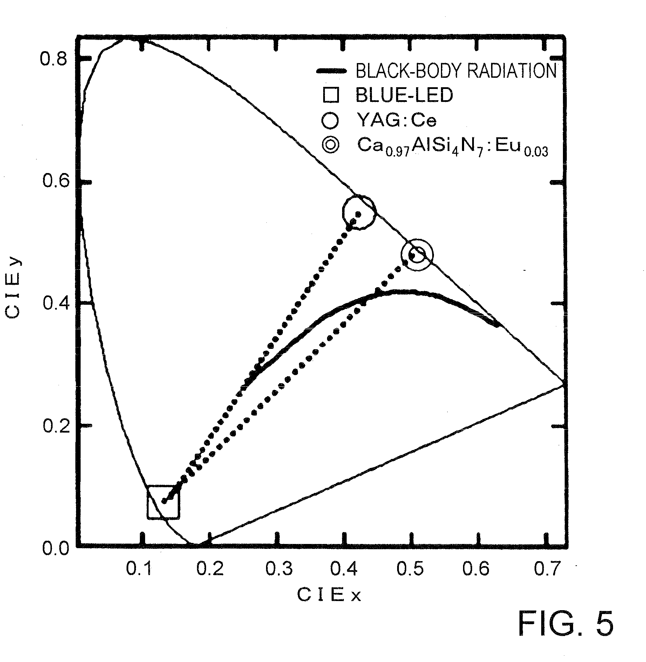

As can seen from the values of CIE chromaticity coordinates and the values of white chromaticity of black-body radiation for the phosphors shown in Fig. 5 and Table 1, the white LED constructed using YAG:Ce emits bluish white light having a white chromaticity of (0.27, 0.28), whereas the white LED constructed using the Ca_{0.97}AlSi₄N₇:Eu_{0.03} yellow-emitting phosphor according to the present invention emits white light of a warm incandescent bulb color having a white chromaticity of (0.43, 0.41).

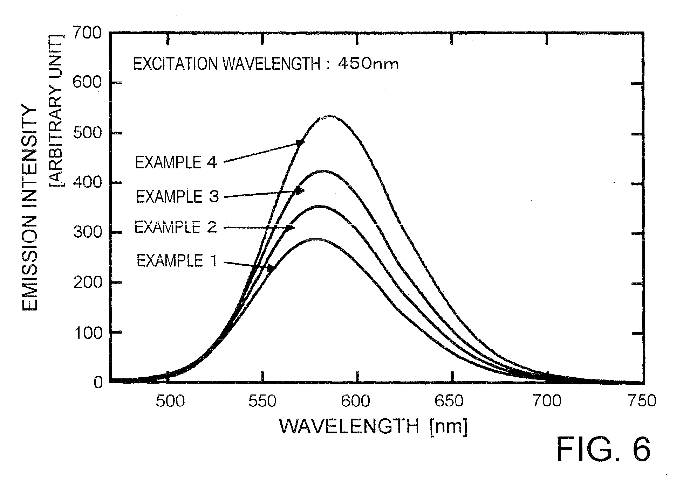

Description will be made of changes in the emission spectrum of the phosphor represented by the general formula: Ca₁₋ₓAlSi₄N₇:Euₓ with varying value of x in the general formula. Table 2 shows the results of measurement of emission intensity ratios and emission peak wavelengths obtained when the value of x was varied. FIG. 6 shows measured emission spectra of phosphors of Examples 1 to 4 shown in Table 2. Excitation light used had a wavelength of 450 nm.

**Table 2**

| EXAMPLES | COMPOSITION | EMISSION PEAK WAVELENGTH | EMISSION INTENSITY RATIO |
|---|---|---|---|
| EXAMPLE 1 | Ca₀.₉₉AlSi₄N₇:Eu_{0.01} | 584 nm | 54 |
| EXAMPLE 2 | Ca₀.₉₈AlSi₄N₇:Eu_{0.02} | 585 nm | 85 |
| EXAMPLE 3 | Ca₀.₉₇AlSi₄N₇:Eu_{0.03} | 589 nm | 100 |
| EXAMPLE 4 | Ca₀.₉₅AlSi₄N₇:Eu_{0.05} | 593 nm | 122 |

As can be seen from Table 2 and FIG. 6, the emission peak wavelength shifts toward a shorter wavelength and the emission intensity ratio lowers with decreasing value of x, *i.e.*, with decreasing amount of doped europium (Eu). When the relative proportion x of europium becomes too small, the emission intensity ratio becomes too low to meet practical use. For this reason, the lower limit of the relative proportion x seems to be about 0.001. On the other hand, when the content of europium is too high, concentration quenching occurs to lower the emission intensity. The emission intensity ratio is maximized when the relative proportion x is about 0.1, and the upper limit of the relative proportion x seems to be about 0.15 to about 0.2.

Description will be made of an exemplary method of preparing one of the yellow-emitting phosphors of the above-described Examples.

Ca₃N₂ powder, AIN powder, Si₃N₄ powder and Eu₂N₃ powder were provided as raw materials and then weighed. Here, 5.1255 g of Ca₃N₂, 13.1482 g of AlN, 20.0000 g of Si₃N₄ and 0.5644 g of Eu₂N₃ were weighed to obtain a target composition: Ca_{0.97}AlSi₄N₇:Eu_{0.03}. Subsequently, dry blending was performed by putting these raw materials into an agate mortar and then mixing the raw materials sufficiently with an agate pestle. A boron nitride crucible was charged with the resulting mixed powder and then set in an electric furnace where the mixed powder was fired at 1600 °C for six hours in a reducing atmosphere in which the ratio of nitrogen: hydrogen was 1:3. After firing, the resulting fired mixture was gradually cooled and then milled and mixed, to give an intended sample.

As described above, the yellow-emitting phosphor according to the present invention can be used to construct a white light emitting device by being combined with a blue LED, UV-LED, or the like. Such a white light emitting device takes a basic form as disclosed in JP-A-10-242513, JP-A-11-046015, JP-A-2005-060714, JP-A-2005-235934, JP-A-10-093146, or JP-A-10-065221, for example.

It is also possible to construct a white light emitting device by combining the yellow-emitting phosphor according to the present invention with a light emitting device other than LEDs, for example, a blue-emitting laser, ultraviolet lamp configured to emit ultraviolet rays, excimer laser configured to emit ultraviolet rays, or the like. Alternatively, the yellow-emitting phosphor of the present invention may be combined with a planar light emitting device which has been intensively developed recently, such as an inorganic EL device or organic EL device, to form a white light emitting device.

In cases where the white light emitting device according to the present invention is used as a lighting device, when a point source, such as an LED or laser device, is used as a light source for exciting the yellow-emitting phosphor, light from such a light source has to be scattered. However, when such a planar light emitting device is used as an excitation light source, it is possible to eliminate the need for scattering light or to scatter light by providing the electrode surface of the planar light emitting device with projections and depressions. Therefore, there is possibility that the use of the planar light emitting device as an excitation light source makes it possible to further improve the light use efficiency.

The white light emitting device according to the present invention can find applications in general household lighting devices and medical lighting devices, as well as applications in light sources for backlights in liquid crystal display devices, and the like.

## Claims

1. A yellow-emitting phosphor represented by the general formula: Ca₁₋ₓAlSi₄N₇:Euₓ.

2. The yellow-emitting phosphor according to claim 1, wherein x is within a range of 0.001 <x≤ 0.15.

3. A white light emitting device configured to emit white light by combining blue light with light emitted from a phosphor which emits light of a complementary color to the blue light, wherein the phosphor is the yellow-emitting phosphor according to claim 1.

4. The white light emitting device according to claim 3, further comprising: a red-emitting phosphor which emits red light; and a green-emitting phosphor which emits green light.

5. A white light emitting device comprising: a blue light emitting device which emits blue light; and the yellow-emitting phosphor according to claim 1 which is capable of being excited by the blue light.

6. The white light emitting device according to claim 5, wherein the blue light emitting device is a blue LED.

7. The white light emitting device according to claim 5, further comprising: a red-emitting phosphor which emits red light; and a green-emitting phosphor which emits green light.

8. A white light emitting device comprising: an ultraviolet emitting device which emits ultraviolet light; a blue-emitting phosphor which emits blue light when excited by the ultraviolet light; and the yellow-emitting phosphor according to claim 1 which is capable of being excited by the ultraviolet light and/or the blue light.

9. The white light emitting device according to claim 8, further comprising: a red-emitting phosphor which emits red light; and a green-emitting phosphor which emits green light.

10. The white light emitting device according to claim 8, wherein the ultraviolet light emitted from the ultraviolet emitting device is an ultraviolet ray having a wavelength of 300 to 400 nm.

11. A lighting device **characterized by** use of the white light emitting device according to claim 3.

12. A lighting device **characterized by** use of the white light emitting device according to claim 5.
